# EUROPÄISCHE PATENTSCHRIFT

(11) **EP 2 803 109 B1**
(45) Veröffentlichungstag und Bekanntmachung des Hinweises auf die Patenterteilung: **14.10.2015**
(21) Anmeldenummer: 12809608.8
(22) Anmeldetag: 14.12.2012
(51) Int. Cl.: H01M 10/42, G01R 31/36

(54) **BATTERIEANORDNUNG FÜR EIN KRAFTFAHRZEUG**
BATTERY ARRANGEMENT FOR A MOTOR VEHICLE
SYSTÈME DE BATTERIE POUR VÉHICULE À MOTEUR

(30) Priorität: 13.01.2012 DE 102012000583
(43) Veröffentlichungstag der Anmeldung: 19.11.2014
(73) Patentinhaber: Audi AG, 85045 Ingolstadt (DE)
(72) Erfinder: SCHMIDT, Jörg, 85057 Ingolstadt (DE); HINTERBERGER, Michael, 85055 Ingolstadt (DE); AVDIC, Reuf, 85055 Ingolstadt (DE); ACIKGOEZ, Erdal, 85084 Reichertshofen (DE); STÖCKERT, Diana, 85055 Ingolstadt (DE)
(74) Vertreter: Herbst, Matthias Heinz
(86) Internationale Anmeldenummer: PCT/EP2012/005165
(87) Internationale Veröffentlichungsnummer: WO 2013/104394

(56) Entgegenhaltungen:
- EP-A1- 1 094 327
- DE-A1- 19 535 675
- DE-A1-102009 046 564
- US-A1- 2007 114 973
- US-A1- 2010 327 878

## Beschreibung

Die vorliegende Erfindung betrifft eine Batterieanordnung für ein Kraftfahrzeug, die eine Mehrzahl von Batteriemodulen umfasst. Überdies betrifft die vorliegende Erfindung ein Kraftfahrzeug. Schließlich betrifft die vorliegende Erfindung ein Verfahren zum Überprüfen einer elektrischen Verbindung zwischen zumindest zwei Batteriemodulen einer Batterieanordnung für ein Kraftfahrzeug.

In Kraftfahrzeugen, insbesondere in Elektrofahrzeugen, werden Anordnungen von mehreren Batteriemodulen verwendet. Solche Batterieanordnungen können beispielsweise als Traktionsbatterien für Elektrofahrzeuge genutzt werden. Hierbei wird eine Mehrzahl von Batteriemodulen elektrisch in Reihe geschaltet, um eine entsprechend hohe Gesamtspannung zu erzielen, damit die geforderte elektrische Leistung übertragen werden kann. Die einzelnen Batteriemodule umfassen üblicherweise eine Mehrzahl von Batteriezellen, die beispielsweise in Reihe geschaltet sind. Diese Batteriezellen bzw. Einzelzellen können Lithium-Ionen-Zellen oder auch Zellen mit einer anderen Zellchemie, beispielsweise Nickel-Metallhydrid-Akkumulatoren (NiMH), sein. Dabei werden lediglich die Zellspannungen an den Einzelzellen durch ein Batteriemanagementsystem überwacht. Dazu wird von jeder Einzelzelle eine entsprechende Messleitung, eine so genannte Senseleitung, in das Batteriemanagementsystem geführt. Beim Aufbau der Batterieanordnung, während dem die einzelnen Batteriemodule elektrisch in Reihe geschaltet werden, kann unter Zuhilfenahme dieser Senseleitungen auch erkannt werden, welche elektrische Spannung im Gesamtsystem der Batterieanordnung bereits erreicht wurde. Durch eine gezielte Einflussnahme auf die Montagereihenfolge ist es dann auch möglich, eine gefährliche Spannung, beispielsweise eine elektrische Spannung >60 V, so spät wie möglich zu erzielen.

Bekannt ist auch der Weg zur Modularisierung eines solchen Batteriesystems. Dabei ist man bestrebt, die Auswertung der jeweiligen Zellspannungen auf Modulebene zu belassen. Die einzelnen Batteriemodule kommunizieren hierbei ihre Messwerte dann über ein entsprechendes Bussystem, insbesondere den CAN-Bus, an eine übergeordnete Überwachungseinrichtung bzw. das Batteriemanagementsystem. Dabei ist jedem Batteriemodul eine Steuereinheit zugeordnet, die dazu ausgebildet ist, die Zellspannungen an den Einzelzellen zu überwachen. Bei einer derartigen Anordnung kennt die jeweilige Steuereinrichtung die Verschaltung in dem Batteriemodul und welche elektrische Spannung von den Einzelzellen in dem Batteriemodul jeweils bereitgestellt wird. Diese Informationen gibt die Steuereinheit an die übergeordnete Überwachungseinrichtung bzw. das Batteriemanagementsystem weiter. In der jeweiligen Steuereinheit liegt allerdings keine Information darüber vor, ob die jeweiligen Batteriemodule elektrisch miteinander verschaltet sind. Somit kann beim Aufbau einer Batterieanordnung die momentan im Gesamtsystem vorliegende elektrische Spannung nicht bestimmt werden. Dies hat wiederum zur Folge, dass nicht ermittelt werden kann, ob durch die elektrische Spannung eine Gefährdung vorliegen kann.

Die DE 198 10 746 B4 beschreibt eine Platine mit einer Schaltung zur Überwachung einer mehrzelligen Akkumulatorbatterie, mit der die elektrische Spannung und die Temperatur der Zellen in der Akkumulatorbatterie erfasst werden kann. Die Platine weist zudem Ein- und Ausgänge auf, die an einen Datenbus angeschlossen sind, der die Batterie mit weiteren Batterien und einem zentralen Batteriemanagementsystem verbindet.

Des Weiteren ist aus der DE 10 2008 058 924 B4 ein Verfahren zur Identifikation und Qualitätsdokumentation von Akkumulatoren für Industriewerkzeuge bekannt. Hierbei können die Akkumulatoren zum Aufladen in einen entsprechenden Adapter eingeführt werden. Zudem ist es auch vorgesehen, dass im Bereich der Adapter elektronische Baugruppen vorgesehen sind, die untereinander über eine Datenleitung verbunden sind.

Eine Batterie mit mehren hintereinandergeschalteten Einzelzellen, die über eine gemeinsame Stromleitung zum Laden der Einzelzellen miteinander verbunden sind, ist in der DE 195 45 833 B4 beschrieben. Hierbei ist jeder Einzelzelle ein entsprechendes Einzelzell-Modul zugeordnet, das die Möglichkeit besitzt, individuelle Ladesignale zu empfangen und umzusetzen. Die Ausgabe der individuellen Ladesignale geschieht durch eine Zentraleinheit über die Stromleitung die als modulierter Feldbus ausgebildet sein kann.

Überdies offenbart die DE 103 37 243 A1 ein Batterieprüfmodul für Akkumulatorbatterien, bei denen in einem Batteriegehäuse eine Mehrzahl von Batteriezellen in Reihe geschaltet ist. Mit dem Batterieprüfmodul können Informationen über die Beschaffenheit der Batterie bereitgestellt werden. Das Batterieprüfmodul ist dazu ausgebildet Daten, wie beispielsweise die Seriennummer der Batterie, zu empfangen und zu übertragen.

Zudem beschreibt die DE 10 2010 016 175 A1 eine Vorrichtung zur Überwachung und Steuerung einer Batterie, wobei jeder Batteriezelle ein Batterieüberwachungsmodul zugeordnet ist. Überdies umfasst die Vorrichtung einen Systemcontroller, der dazu ausgebildet ist, die Batteriemodule zu überwachen, Daten von diesen abzurufen und Befehle zur Steuerung des Ladeausgleichs auszuführen. Zudem sind die Spannungspotentiale zwischen mehreren Batterieüberwachungsmodulen so miteinander verknüpft, dass die Spannung über jedes der Batterieüberwachungsmodule geregelt werden kann.

Schließlich beschreibt die US 2010/0327878 A1 eine Vorrichtung zum Trennen einer elektrischen Verbindung für eine Batterie eines Kraftfahrzeugs. Die Batterie des Kraftfahrzeugs umfasst mehrere Batteriemodule, wobei jedem der Batteriemodule eine jeweilige Schaltung zum Bestimmen der Spannung zugeordnet ist. Die einzelnen Schaltungen zum Bestimmen der elektrischen Spannung sind mittels einer Datenleitung seriell miteinander verbunden.

Es ist Aufgabe der vorliegenden Erfindung, das Anordnen einer Mehrzahl von Batteriemodulen zu einer Batterieanordnung für ein Kraftfahrzeug auf einfache Weise besonders sicher zu gestalten.

Diese Aufgabe wird erfindungsgemäß durch eine Batterieanordnung gemäß Patentanspruch 1 und durch ein Kraftfahrzeug gemäß Patentanspruch 6 gelöst. In gleicher Weise wird diese Aufgabe durch ein Verfahren gemäß Patentanspruch 7 gelöst. Vorteilhafte Weiterbildungen der vorliegenden Erfindung sind in den Unteransprüchen angegeben.

Die erfindungsgemäße Batterieanordnung für ein Kraftfahrzeug umfasst eine Mehrzahl von Batteriemodulen, wobei jedes der Batteriemodule eine Mehrzahl von Batteriezellen umfasst, von denen jede mit einer Messleitung gekoppelt ist, mit einer jeweiligen Steuereinheit gekoppelt ist, mit der ein Wert für eine Zellspannung an jeder der Messleitungen der Batteriezellen bestimmbar ist und jeweils mit einem benachbarten Batteriemodul elektrisch koppelbar ist, wobei zumindest eine erste Messleitung einer der Batteriezeilen in einem ersten Batteriemodul mit einer Steuereinheit eines benachbarten zweiten Batteriemoduls gekoppelt ist, wobei mit der Steuereinheit des benachbarten zweiten Batteriemoduls ein Wert für die Zellspannung an der ersten Messleitung bestimmbar ist. Des Weiteren ist ein Niedervoltkabel zum Versorgen der Steuereinheiten des ersten und des benachbarten zweiten Batteriemoduls mit elektrischer Energie vorgesehen, wobei das Niedervoltkabel ein elektrisches Leitungselement umfasst, über welches die erste Messleitung mit der Steuereinheit des benachbarten zweiten Batteriemoduls gekoppelt ist.

Wenigstens eine der Messleitungen bzw. Senseleitungen in dem Batteriemodul, die eigentlich nur in die erste Steuereinheit des Batteriemoduls geführt werden, werden nun auch in die zweite Steuereinheit des benachbarten Batteriemoduls geführt. Diese Verbindung der ersten Messleitung zumindest einer Batteriezelle in dem Batteriemodul mit der zweiten Steuereinheit des benachbarten Batteriemoduls kann vor der elektrischen Verbindung der Batteriemodule erfolgen bzw. vorhanden sein. Sie kann aber auch erst dann erfolgen, wenn die benachbarten Batteriemodule elektrisch miteinander verbunden sind. Dies kann beispielsweise mit einer entsprechenden Hochvoltleitung erfolgen, mit der benachbarte Batteriemodule zum Übertragen der elektrischen Energie in Reihe geschaltet werden können. Somit können in einer Batterieanordnung für ein Kraftfahrzeug, das mehrere Batteriemodule umfasst, jeweils zumindest eine Messleitung eines Batteriemoduls an das benachbarte Batteriemodul übergeben werden und dort auch in die jeweilige Steuereinheit geführt werden. Damit sind die jeweiligen Steuereinheiten auch dazu ausgebildet, elektrische Spannungen zu messen, die modulübergreifend durch die Verbindung der Batteriemodule entsteht.

Benachbarte Batteriemodule sind mit einem Niedervoltkabel bzw. einem Low-Volt-Kabel elektrisch verbunden. Über dieses Low-Volt-Kabel bzw. die jeweiligen dazugehörigen Low-Volt-Stecker wird nun auch eine elektrische Verbindung bereitgestellt, mit der die Messleitung einer Batteriezelle des Batteriemoduls zu der Steuereinheit des benachbarten Batteriemoduls geführt wird. Somit kann auf einfache Weise eine elektrische Verbindung der ersten Messleitung zu der zweiten Steuereinheit des benachbarten Batteriemoduls ermöglicht werden.

Bevorzugt ist mit der Steuereinheit des benachbarten zweiten Batteriemoduls ein Wert für eine elektrische Spannung zwischen der ersten Messleitung und einer zweiten Messleitung einer Batteriezelle in dem benachbarten zweiten Batteriemodul bestimmbar. Wenn das Batteriemodul mit dem benachbarten Batteriemodul elektrisch verbunden ist, ergibt sich ein anderer Wert für die elektrische Spannung zwischen der ersten und der zweiten Messleitung im Vergleich zu einem Zustand, in dem die beiden Batteriemodule elektrisch nicht verbunden sind. Der Potentialunterschied zwischen der ersten und der zweiten Messleitung kann im einfachsten Fall den Wert Null annehmen, wenn das Batteriemodul mit dem benachbarten Batteriemodul elektrisch verbunden ist. Der Spannungsunterschied kann auch einen Wert annehmen, der der Summe der Zellspannungen entspricht, die zwischen den Messleitungen angeordnet sind. Somit kann beim Aufbau der Batterieanordnung auf einfach Weise festgestellt werden, ob benachbarte Batteriemodule elektrisch miteinander verbunden sind.

In einer Ausführungsform ist jede der Steuereinheiten dazu ausgebildet, die Werte für die jeweilige Zellspannung an den Messleitungen, mit denen die Steuereinheit gekoppelt ist, über einen Datenbus an eine übergeordnete Überwachungseinrichtung zu senden. Die Steuereinheiten in den Batterieanordnungen sind üblicherweise über einen Datenbus, insbesondere den CAN-Bus, mit einer übergeordneten Überwachungseinrichtung bzw. einem Batteriemanagementsystem verbunden. Die jeweiligen Steuereinheiten senden nun die jeweiligen Werte für die Zellspannungen an die Messleitungen, mit denen sie verbunden sind, an die übergeordnete Überwachungseinrichtung. Somit können auch die Werte für die Zellspannungen von Messleitungen von benachbarten Batteriemodulen, die mit der jeweiligen Steuereinrichtung erfasst werden, an die Überwachungseinrichtung gesendet werden. Damit liegt in der Überwachungseinrichtung eine Information darüber vor, welche Spannungen an den jeweiligen Messleitungen der jeweiligen Steuereinheit bestimmt sind.

In einer Ausführungsform umfasst die Batterieanordnung eine Messeinrichtung, mit der anhand der an die Überwachungseinrichtung gesendeten Werte ein Vorhandensein einer elektrischen Verbindung zwischen den benachbarten Batteriemodulen bestimmbar ist. In der übergeordneten Überwachungseinrichtung sind die Werte für die Zellspannungen jeder der Steuereinheiten hinterlegt. Diese Werte beinhalten auch jeweils die Werte für die Zellspannungen, die die jeweilige Steuereinheit von einer Messleitung einer benachbarten Steuereinheit erfasst. In Abhängigkeit von dem Wert für die elektrische Spannung, der von der jeweiligen Steuereinheit an der Messleitung des benachbarten Batteriemoduls erfasst wird, kann mit der Messeinrichtung somit auf einfache Weise ermittelt werden, ob benachbarte Batteriemodule elektrisch verbunden sind oder nicht.

Ist die elektrische Spannung, die mit jedem der Batteriemodule in der Batterieanordnung erzeugt werden kann, bekannt, kann zusätzlich mit der Messeinrichtung die Gesamtspannung in dem System ermittelt werden. Bevorzugt sind alle Batteriemodule gleich aufgebaut bzw. können die gleiche elektrische Spannung bereitstellen. Somit kann auf einfache Weise darauf geschlossen werden, welche elektrische Spannung im Gesamtsystem der Batterieanordnung momentan anliegt.

In einer weiteren Ausgestaltung ist mit der Messeinrichtung ein Warnsignal ausgebaut, falls die durch die elektrische Verbindung zwischen den benachbarten Batteriemodulen bereitgestellte elektrische Spannung einen vorgegebenen Grenzwert überschreitet. So kann die Messeinrichtung ein entsprechendes Warnsignal abgeben, falls die Gesamtspannung in der Batterieanordnung einen sicherheitskritischen Wert überschreitet. Beispielsweise kann die Messeinrichtung ein Warnsignal ausgeben, falls die elektrische Spannung in der Batterieanordnung 60 V überschreitet. Somit kann die Sicherheit während des Aufbaus der Batterieanordnung gewährleistet werden.

Das erfindungsgemäße Kraftfahrzeug umfasst die zuvor beschriebene Batterieanordnung. Insbesondere ist das Kraftfahrzeug ein Elektrofahrzeug und die Batterieanordnung wird als Traktionsbatterie für das Elektrofahrzeug verwendet.

Das erfindungsgemäße Verfahren zum Überprüfen einer elektrischen Verbindung zwischen zumindest zwei Batteriemodulen einer Batterieanordnung für ein Kraftfahrzeug, umfasst das Bereitstellen der Batteriemodule, wobei jedes der Batteriemodule eine Mehrzahl von Batteriezellen umfasst von denen jede mit einer Messleitung gekoppelt ist und mit einer jeweiligen Steuereinheit gekoppelt ist, mit der ein Werts für eine Zellspannung an jeder der Messleitungen bestimmbar ist, und das elektrisches Verbinden eines ersten Batteriemoduls mit einem benachbarten zweiten Batteriemodul, das Koppeln einer ersten Messleitung einer Batteriezelle des ersten Batteriemodul mit einer Steuereinheit des benachbarten zweiten Batteriemoduls, das Bestimmen eines Werts für die Zellspannung an der ersten Messleitung mit der Steuereinheit des benachbarten zweiten Batteriemoduls und das Überprüfen einer elektrischen Verbindung zwischen dem ersten Batteriemodul und dem benachbarten zweiten Batteriemodul anhand des von der Steuereinheit des benachbarten zweiten Batteriemoduls an der ersten Messleitung bestimmten Werts für die Zellspannung, das Bereitstellen eines Niedervoltkabels zum Versorgen der Steuereinheiten des ersten und des benachbarten zweiten Batteriemoduls mit elektrischer Energie, wobei das Niedervoltkabel ein elektrisches Leitungselement umfasst, und das Koppeln der ersten Messleitung mit der Steuereinheit des benachbarten zweiten Batteriemoduls über das elektrische Leitungselement des Niedervoltkabels.

Die zuvor im Zusammenhang mit der erfindungsgemäßen Batterieanordnung beschriebenen Vorteile und Weiterbildungen können in gleicher Weise auf das erfindungsgemäße Kraftfahrzeug und das erfindungsgemäße Verfahren übertragen werden.

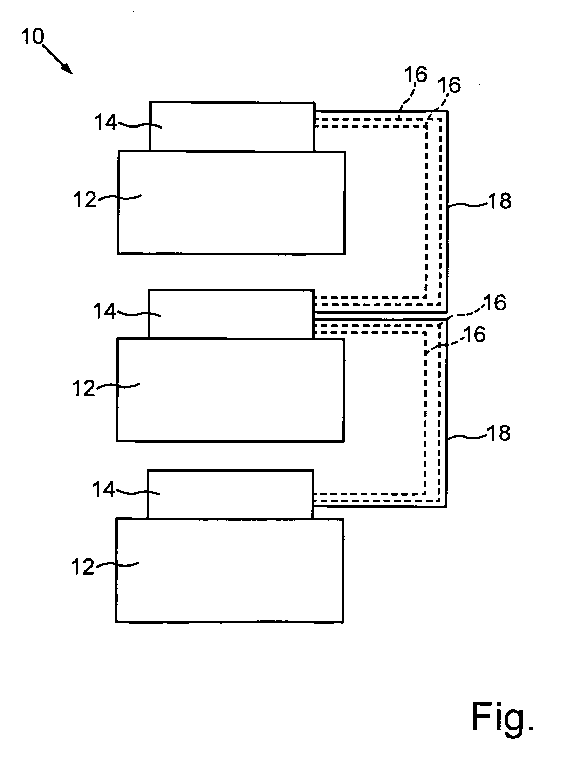

Die vorliegende Erfindung wird nun anhand der beigefügten Zeichnungen näher erläutert. Dabei zeigt die einzige Figur eine schematische Darstellung einer Batterieanordnung für ein Kraftfahrzeug.

Das nachfolgend näher geschilderte Ausführungsbeispiel stellt eine bevorzugte Ausführungsform der vorliegenden Erfindung dar.

Die Figur zeigt eine schematische Darstellung einer Batterieanordnung 10. Diese Batterieanordnung 10 dient insbesondere der Verwendung in einem Kraftfahrzeug, insbesondere in einem Elektrofahrzeug. Bevorzugt kann die Batterieanordnung 10 als Traktionsbatterie für ein Elektrofahrzeug verwendet werden. Die Batterieanordnung 10 umfasst eine Mehrzahl von Batteriemodulen 12. Im vorliegenden Beispiel umfasst die Batterieanordnung 10 drei Batteriemodule 12.

Jedes der Batteriemodule 12 umfasst eine Mehrzahl von Batteriezellen, die in der Figur nicht näher dargestellt sind. Diese Batteriezellen bzw. Einzelzellen können beispielsweise Lithium-Ionen-Zellen sein. Ebenso sind Batteriezellen mit einer anderen Zellchemie denkbar. Bevorzugt ist an jeder Batteriezellen eine Messleitung 18 bzw. eine Senseleitung angebracht. Zudem ist jedes Batteriemodul 12 mit einer Steuereinheit 14 gekoppelt. Die Steuereinheit 14 ist mit den jeweilige Messleitungen 18 bzw. Senseleitungen des ihr zugeordneten Batteriemoduls 12 elektrisch verbunden. Die Steuereinheit 14 ist dazu ausgebildet, über die jeweiligen Messleitungen 18 die Zellspannung an jeder Einzelzelle des Batteriemoduls 12 zu überwachen.

Die einzelnen Steuereinheiten 14 sind mit einem Datenbus 16, insbesondere dem CAN-Bus, miteinander verbunden. Zudem sind die Steuereinheiten 14 mit einer hier nicht dargestellten übergeordneten Überwachungseinrichtung der Batterieanordnung 10 über den Datenbus 16 verbunden. Die Steuereinheiten 14 können die Werte für die Zellspannungen, die sie an den jeweiligen Messleitungen 18 der Einzelzellen der ihr zugeordneten Batteriemodule 12 ermitteln, an die übergeordnete Steuereinheit senden.

Vorliegend ist zumindest eine Messleitung 18 einer Batteriezelle eines Batteriemoduls 12 mit der Steuereinheit 14 des benachbarten Batteriemoduls 12 elektrisch verbunden bzw. gekoppelt. Somit wird zumindest eine Messleitung 18 eines Batteriemoduls 12 jeweils an die Steuereinheit 14 des benachbarten Batteriemoduls 12 übergeben. Somit können mit den jeweiligen Steuereinheiten 14 auch modulübergreifende elektrische Spannungen gemessen werden. Aus dieser modulübergreifenden Spannung bzw. dem jeweiligen Potentialunterschied kann bestimmt werden, ob die Batteriemodule 12 elektrisch miteinander verbunden sind oder nicht.

Zu diesem Zweck kann Batterieanordnung 10 beispielsweise eine entsprechende Messeinrichtung umfassen, die anhand der von der jeweiligen Steuereinheit 14 ermittelten Werte für die Zellspannungen ermitteln kann, ob eine elektrische Verbindung zwischen zumindest benachbarten Batteriemodulen 12 vorliegt oder nicht. Wenn zusätzlich die elektrische Spannung, die von dem jeweiligen Batteriemodul 12 bereitgestellt werden kann, bekannt ist, kann mit der Messeinrichtung zusätzlich bestimmt werden, welche elektrische Spannung im Gesamtsystem der Batterieanordnung 10 vorliegt. Bevorzugt wird von jeder der Batteriemodule 12 die gleiche elektrische Spannung bereitgestellt. Die Messeinrichtung kann zusätzlich dazu ausgebildet sein, ein entsprechendes Warnsignal auszugeben, falls die elektrische Spannung in der Batterieanordnung 10 einen vorgegebenen Grenzwert überschreitet. Somit kann die Sicherheit beim Aufbau der Batterieanordnung 10 bzw. beim elektrischen Verbinden der Batteriemodule 12 gewährleistet werden.

## Patentansprüche

1. Batterieanordnung (10) für ein Kraftfahrzeug mit einer Mehrzahl von Batteriemodulen (12), wobei jedes der Batteriemodule (12)
- eine Mehrzahl von Batteriezellen umfasst, von denen jede mit einer Messleitung (18) gekoppelt ist,
- mit einer jeweiligen Steuereinheit (14) gekoppelt ist, mit der ein Wert für eine Zellspannung an jeder der Messleitungen (18) der Batteriezellen bestimmbar ist, und
- jeweils mit einem benachbarten Batteriemodul (12) elektrisch koppelbar ist, wobei
- zumindest eine erste Messleitung (18) einer der Batteriezellen in einem ersten Batteriemodul (12) mit einer Steuereinheit (14) eines benachbarten zweiten Batteriemoduls (12) gekoppelt ist, wobei mit der Steuereinheit (14) des benachbarten zweiten Batteriemoduls (12) ein Wert für die Zellspannung an der ersten Messleitung (18) bestimmbar ist,
**dadurch gekennzeichnet, dass**
- ein Niedervoltkabel zum Versorgen der Steuereinheiten (14) des ersten und des benachbarten zweiten Batteriemoduls (12) mit elektrischer Energie vorgesehen ist, wobei das Niedervoltkabel ein elektrisches Leitungselement umfasst, über welches die erste Messleitung (18) mit der Steuereinheit (14) des benachbarten zweiten Batteriemoduls (12) gekoppelt ist.

2. Batterieanordnung (10) nach Anspruch 1,
**dadurch gekennzeichnet, dass**
mit der Steuereinheit (14) des benachbarten zweiten Batteriemoduls (12) ein Wert für eine elektrische Spannung zwischen der ersten Messleitung (18) und einer zweiten Messleitung (18) einer Batteriezelle in dem benachbarten zweiten Batteriemodul (12) bestimmbar ist.

3. Batterieanordnung (10) nach Anspruch 1 oder 2,
**dadurch gekennzeichnet, dass**
jede der Steuereinheiten (14) dazu ausgebildet ist, die Werte für die jeweilige Zellspannung an den Messleitungen (18), mit denen die Steuereinheit (14) gekoppelt ist, über einen Datenbus an eine übergeordnete Überwachungseinrichtung zu senden.

4. Batterieanordnung (10) nach Anspruch 3,
**dadurch gekennzeichnet, dass**
die Batterieanordnung (10) eine Messeinrichtung umfasst, mit der anhand der an die Überwachungseinrichtung gesendeten Werte ein Vorhandensein einer elektrischen Verbindung zwischen den benachbarten Batteriemodulen (12) bestimmbar ist.

5. Batterieanordnung (10) nach Anspruch 4,
**dadurch gekennzeichnet, dass**
mit der Messeinrichtung ein Warnsignal ausgebbar ist, falls die durch die elektrische Verbindung zwischen den benachbarten Batteriemodulen (12) bereitgestellte elektrische Spannung einen vorgegebenen Grenzwert überschreitet.

6. Kraftfahrzeug mit einer Batterieanordnung (10) nach einem der vorhergehenden Ansprüche.

7. Verfahren zum Überprüfen einer elektrischen Verbindung zwischen zumindest zwei Batteriemodulen (12) einer Batterieanordnung (10) für ein Kraftfahrzeug, durch
- Bereitstellen der Batteriemodule (12), wobei jedes der Batteriemodule (12) eine Mehrzahl von Batteriezellen umfasst von denen jede mit einer Messleitung (18) gekoppelt ist und mit einer jeweiligen Steuereinheit (14) gekoppelt ist, mit der ein Werts für eine Zellspannung an jeder der Messleitungen (18) bestimmbar ist,
- Elektrisches Verbinden eines ersten Batteriemoduls (12) mit einem benachbarten zweiten Batteriemodul (12),
- Koppeln einer ersten Messleitung (18) einer Batteriezelle des ersten Batteriemodul (12) mit einer Steuereinheit (14) des benachbarten zweiten Batteriemoduls (12),
- Bestimmen eines Werts für die Zellspannung an der ersten Messleitung (18) mit der Steuereinheit (14) des benachbarten zweiten Batteriemoduls (12), und
- Überprüfen einer elektrischen Verbindung zwischen dem ersten Batteriemodul (12) und dem benachbarten zweiten Batteriemodul (12) anhand des von der Steuereinheit (14) des benachbarten zweiten Batteriemoduls (12) an der ersten Messleitung (18) bestimmten Werts für die Zellspannung,
**gekennzeichnet durch**
- Bereitstellen eines Niedervoltkabels zum Versorgen der Steuereinheiten (14) des ersten und des benachbarten zweiten Batteriemoduls (12) mit elektrischer Energie, wobei das Niedervoltkabel ein elektrisches Leitungselement umfasst, und
- Koppel der ersten Messleitung (18) mit der Steuereinheit (14) des benachbarten zweiten Batteriemoduls (12) über das elektrische Leitungselement des Niedervoltkabels.

## Claims

1. Battery arrangement (10) for a motor vehicle comprising a plurality of battery modules (12), wherein each of the battery modules (12)
- comprises a plurality of battery cells, each of which is coupled to a measuring cable (18),
- is coupled to a respective control unit (14), by means of which a value for a cell voltage can be determined at each of the measuring cables (18) of the battery cells, and
- can be electrically coupled respectively to an adjacent battery module (12) wherein
- at least one first measuring cable (18) of one of the battery cells is coupled in a first battery module (12) to a control unit (14) of an adjacent second battery module (12), wherein by means of the control unit (14) of the adjacent second battery module (12) a value for the cell voltage can be determined at the first measuring cable (18),
**characterised in that**
- a low-voltage cable is provided for supplying the control units (14) of the first and the adjacent second battery module (12) with electric power, wherein the low-voltage cable comprises an electric line element, by means of which the first measuring cable (18) is coupled to the control unit (14) of the adjacent second battery module (12).

2. Battery arrangement (10) according to claim 1, **characterised in that** by means of the control unit (14) of the adjacent second battery module (12) a value can be determined for an electric voltage between the first measuring cable (18) and a second measuring cable (18) of a battery cell in the adjacent second battery module (12).

3. Battery arrangement (10) according to either claim 1 or claim 2, **characterised in that** each of the control units (14) is designed to send the values for the respective cell voltage to the measuring cables (18), to which the control unit (14) is coupled, via a data bus to a superordinate monitoring device.

4. Battery arrangement (10) according to claim 3, **characterised in that** the battery arrangement (10) comprises a measuring device, by means of which the existence of an electrical connection between the adjacent battery modules (12) can be determined with reference to values sent to the monitoring device.

5. Battery arrangement (10) according to claim 4, **characterised in that** by means of the measuring device a warning signal can be emitted if the electric voltage provided by the electrical connection between the adjacent battery modules (12) exceeds a predetermined threshold value.

6. Motor vehicle comprising a battery arrangement (10) according to any one of the preceding claims.

7. Method for checking an electrical connection between at least two battery modules (12) of a battery arrangement (10) for a motor vehicle by
- providing the battery modules (12), wherein each of the battery modules (12) comprises a plurality of battery cells, each of which is coupled to a measuring cable (18) and is coupled to a respective control unit (14), by means of which a value for a cell voltage can be determined at each of the measuring cables (18),
- electrically connecting a first battery module (12) to an adjacent second battery module (12),
- coupling a first measuring cable (18) of a battery cell of the first battery module (12) to a control unit (14) of the adjacent second battery module (12),
- determining a value for the cell voltage at the first measuring cable (18) by the control unit (14) of the adjacent second battery module (12), and
- checking an electrical connection between the first battery module (12) and the adjacent second battery module (12) by means of the value for the cell voltage determined by the control unit (14) of the adjacent second battery module (12) at the first measuring cable (18), **characterised by**
- providing a low-voltage cable for supplying the control units (14) of the first and adjacent second battery module (12) with electric power, wherein the low-voltage cable comprises an electric line element and
- coupling the first measuring cable (18) to the control unit (14) of the adjacent second battery module (12) via the electric line element of the low-voltage cable.

## Revendications

1. Système de batterie (10) destiné à un véhicule automobile avec une multiplicité de modules de batterie (12), dans lequel chacun des modules de batterie (12)
- comprend une multiplicité de cellules de batterie, dont chacune est couplée à une ligne de mesure (18),
- est couplé à une unité de commande respective (14) avec laquelle une valeur pour une tension de cellule peut être déterminée au niveau de chacune des lignes de mesure (18) des cellules de batterie, et
- peut être couplé électriquement à chaque fois à un module de batterie (12) voisin,
- au moins une première ligne de mesure (18) de l'une des cellules de batterie dans un premier module de batterie (12) étant couplée à une unité de commande (14) d'un deuxième module de batterie (12) voisin, une valeur pour la tension de cellule pouvant être déterminée au niveau de la première ligne de mesure (18) avec l'unité de commande (14) du deuxième module de batterie (12) voisin,
**caractérisé en ce que**
- un câble à basse tension est prévu pour alimenter en énergie électrique les unités de commande (14) du premier module de batterie et du deuxième module de batterie (12) voisin, le câble à basse tension comprenant un élément conducteur électrique par l'intermédiaire duquel la première ligne de mesure (18) est couplée à l'unité de commande (14) du deuxième module de batterie (12) voisin.

2. Système de batterie (10) selon la revendication 1, **caractérisé en ce que**, avec l'unité de commande (14) du deuxième module de batterie (12) voisin, une valeur.pour une tension électrique entre la première ligne de mesure (18) et une deuxième ligne de mesure (18) d'une cellule de batterie dans le deuxième module de batterie (12) voisin peut être déterminée.

3. Système de batterie (10) selon la revendication 1 ou 2, **caractérisé en ce que** chacune des unités de commande (14) est conçue pour envoyer les valeurs pour la tension de cellule respective au niveau des lignes de mesure (18), auxquelles l'unité de commande (14) est couplée, à un dispositif de surveillance de rang supérieur par l'intermédiaire d'un bus de données.

4. Système de batterie (10) selon la revendication 3, **caractérisé en ce que** le système de batterie (10) comprend un dispositif de mesure avec lequel, à l'aide des valeurs envoyées au dispositif de surveillance, la présence d'une liaison électrique entre les modules de batterie (12) voisins peut être déterminée.

5. Système de batterie (10) selon la revendication 4, **caractérisé en ce que**, avec le dispositif de mesure, un signal d'avertissement peut être émis si la tension électrique fournie par la liaison électrique entre les modules de batterie (12) voisins dépasse une valeur limite prescrite.

6. Véhicule automobile avec un système de batterie (10) selon l'une des revendications précédentes.

7. Procédé pour la vérification d'une liaison électrique entre au moins deux modules de batterie (12) d'un système de batterie (10) destiné à un véhicule automobile, par
- la fourniture de modules de batterie (12), chacun des modules de batterie (12) comprenant une multiplicité de cellules de batterie, dont chacune est couplée à une ligne de mesure (18), et étant couplé à une unité de commande respective (14) avec laquelle une valeur pour une tension de cellule peut être déterminée au niveau de chacune des lignes de mesure (18),
- la liaison électrique d'un premier module de batterie (12) à un deuxième module de batterie (12) voisin,
- le couplage d'une première ligne de mesure (18) d'une cellule de batterie du premier module de batterie (12) à une unité de commande (14) du deuxième module de batterie (12) voisin,
- la détermination, avec l'unité de commande (14) du deuxième module de batterie (12) voisin, d'une valeur pour la tension de cellule au niveau de la première ligne de mesure (18)
- et la vérification d'une liaison électrique entre le premier module de batterie (12) et le deuxième module de batterie (12) voisin à l'aide de la valeur déterminée pour la tension de cellule au niveau de la première ligne de mesure (18) par l'unité de commande (14) du deuxième module de batterie (12) voisin,
**caractérisé par**
- la fourniture d'un câble à basse tension pour alimenter en énergie électrique les unités de commande (14) du premier module de batterie et du deuxième module de batterie (12) voisin, le câble à basse tension comprenant un élément conducteur électrique,
- et le couplage de la première ligne de mesure (18) à l'unité de commande (14) du deuxième module de batterie (12) voisin par l'intermédiaire de l'élément conducteur électrique du câble à basse tension.
